Europäisches Patentamt

European Patent Office

Office européen des brevets

(19)

(11) Publication number: **0 250 250**
A2

# (12) EUROPEAN PATENT APPLICATION

(21) Application number: **87305433.2**

(22) Date of filing: **18.06.87**

(51) Int. Cl.⁴: **H 05 K 9/00**

(30) Priority: **18.06.86 IE 3208/85**

(43) Date of publication of application: **23.12.87**
**Bulletin 87/52**

(84) Designated Contracting States: **AT BE CH DE ES FR GB
GR IT LI LU NL SE**

(71) Applicant: **SECURI-TEC LIMITED, Baybush, Straffan
County Kildare (IE)**

(72) Inventor: **Prendergast, Patrick Thomas, Baybush,
Straffan County Kildare (IE)**
Inventor: **Prendergast, Leo Joseph, Baybush, Straffan
County Kildare (IE)**
Inventor: **Shanahan-Prendergast, Elizabeth, Baybush,
Straffan County Kildare (IE)**
Inventor: **Prendergast, Leo, Sr., Baybush, Straffan
County Kildare (IE)**
Inventor: **Prendergast, Maureen, Baybush, Straffan
County Kildare (IE)**

(74) Representative: **Thiemann, Peter Albert William et al,
LLOYD WISE, TREGEAR & CO. Norman
House 105-109 Strand, London WC2R 0AE (GB)**

(54) **An electro-magnetic wave shield.**

(57) The invention provides a cabinet (1) for electronic appara-
tus to prevent the emission of electro-magnetic signals from
the apparatus. The cabinet (1) is of a cementitious composition
and comprises a base and top member (2) and (3), side walls
(4) and front and rear walls (5) and (6). A screen (31) of clear
perspex is provided in the front wall (5). A polymer is added to
the cementitious composition to make the composition work-
able to that it can be formed into sheet from which the panels
of the cabinet are formed by moulding between a pair of moulds
in a press. Suppressing means to suppress the emission of the
electro-magnetic signals are provided by mixing metal particles
into the cementitious composition. Alternatively, the cabinet
(1) may be provided without suppressing means.

The present invention relates to a shield for electronic or other apparatus to prevent, reduce or distort the emission and/or reception of radiated signals, for example, electro-magnetic signals, radio wave, low frequency electro-magnetic waves, magnetic pulsed fields, ultra high frequency waves, very high frequency waves, X-rays, $\gamma$-rays, microwaves or the like, which signals are hereinafter referred to as electromagnetic signals, and in particular though not limited the invention relates to a shield, for example, a cabinet for shielding electronic data processing apparatus. The invention also relates to a cabinet for electronic apparatus with non-shielding characteristics.

It has been known for some time that certain units of data processing hardware, such as, for example, a visual display unit, a keyboard and their connecting cables and the like, during operation emit radio frequency signals, particularly in commonly used television broadcast bands 1 and 3. These signals are modulated and are in the form of harmonics and carry a signal with the same information content as the signal being processed. In the case of visual display units, an extended pulse chain is emitted equivalent to the information being displayed on the screen of the individual display unit. Such emissions can occur from any type of electronic equipment besides data processing equipment. Needless to say, these broadcasts are unintentional and are incidental to the normal operation of the data processing apparatus.

However, it has been found that readily available equipment may be used to remotely receive and amplify these signals. The signals can then be displayed on the visual display unit. It has been found that these signals may be picked up at distances of the order of one thousand metres from their source. This presents considerable problems with confidential data. In fact, as a result of this, secrecy of records in banks, insurance companies, hospitals, solicitors offices, accounts departments, personnel departments, research establishments, defence systems, government services etc. can no longer be guaranteed.

Some efforts have been made to provide shields for shielding such equipment to prevent the emission of radio frequency waves. However, in general these have tended to be unsatisfactory. In most cases, the shields are either too expensive or not sufficiently versatile for use in the average office or the like, or indeed for whatever other use it may be desired to put them. For example, it is known to mount heavy lead or other metal shields around the electronic circuitry within the housing of apparatus, and while this does undoubtedly reduce the emission of radio frequency waves, these devices are totally unsuitable for use in an office or any other such use, where it is necessary to be able to easily move a piece of data processing equipment or other electronic apparatus from one location to another. Needless to say, where lead shields are used, the resulting piece of equipment tends to be relatively heavy and bulky. Another alternative is to mount the entire apparatus in a heavy metal casing, again this has the problem that the resulting piece of apparatus is relatively heavy and also cumbersome and thus cannot be moved from place to place within an office easily.

An example of a heavy metal enclosure type shield is illustrated in U.S. Patent Specification No. 4,381,421. Another example of shield is illustrated in U.S. Patent Specification No. 4,514,585, however, both these devices comprise cabinets which are relatively heavy and also tend to be relatively expensive.

Other problems with electronic apparatus, particularly apparatus which is sensitive to interference from radiated electro-magnetic waves from external sources is that where such apparatus is subjected to external electro-magnetic waves, it may fail to function, or where it does function, it may function incorrectly or irregularly, and may also give spurious results.

There is therefore a need for a shield for electronic data processing hardware units, and indeed any other electronic apparatus which overcomes the problems associated with known shields.

Furthermore, cabinets for electronic apparatus such as for example, visual display units and the like are, in general, constructed of plastics material. This is a relatively high cost material and is relatively expensive to work. For example, where a cabinet is injection moulded of plastics material, the cost of tools, moulds, jigs and fixtures is relatively high. There is therefore a need for a cabinet for electronic apparatus which is relatively low cost and relatively lightweight with or without shielding properties against electro-magnetic signals.

One object of the invention is to provide a shield for electronic apparatus which prevents, reduces or distorts the emission of radiated signals from the electronic apparatus, for example, electro-magnetic signals, radio waves, low frequency electro-magnetic waves, magnetic pulsed fields, ultra-high frequency waves, very high frequency waves, microwaves or the like. It is also an object of the invention to provide a shield for electronic apparatus which shields the apparatus from such radiation from other sources or if it does not totally shield the apparatus from such signals, it at least reduces the intensity of the signals or distants them so that they have little effect on the apparatus. In particular, it is an object of the invention to provide such a shield or shields which are relatively lightweight, relatively easily and inexpensively manufactured and produced, and also relatively inexpensive. It is an object of the invention to provide such a shield which may be either provided for fitting as an original cabinet for electronic apparatus, such as, for example, the housing of a visual display unit or the like, or which may be suitable for retrofitting to existing electronic apparatus. It is also an object of the invention to provide a shield which is relatively lightweight.

Furthermore, is is an object of the present invention to provide a cabinet with or without shielding properties against electro-magnetic waves of the type hereinbefore described which is relatively low cost and lightweight.

According to the invention, there is provided a shield for electronic apparatus to prevent, reduce or distort emission and/or reception of radiated electro-magnetic signals of the type hereinbefore defined, the shield comprising a housing defining an interior region for receiving the electronic apparatus, at least portion of the housing being of a cementitious composition, and suppressing means for preventing, reducing or distorting the electro-magnetic signals.

The advantages of the invention are many, however, by virtue of the fact that the shield comprises a housing of a cementitious composition, the shield is relatively inexpensive and also relatively lightweight. It is also ideally suited for forming into a cabinet for use as an original cabinet for electronic apparatus or it is suitable for forming into a cabinet suitable for retrofitting to existing equipment and apparatus.

In one embodiment of the invention, the cementitious composition comprises at least one hydraulic cement. The advantage of using a hydraulic cement is that a relatively strong cabinet is provided.

Preferably, the cementitious composition comprises at least one polymeric water soluble or water dispersible additive which is capable of aiding in the processing of the composition. Preferably, the additive enables the cementitious composition to be rolled into sheets or pressed into sheets which are then suitable for forming by any suitable formation process. It has been found that such an additive may be an organic or inorganic additive. One preferred type of additive is polyvinyl acetate and another preferred type is polyacrylomide. It has been found that the addition of these additives gives the composition a doughlike consistency which enables a sheet of a rather rubbery consistency to be formed by rolling the composition between a pair of calendar rollers. In general, the additive may be added in a proportion of 0.1% to 40% by weight of the hydraulic cement in the composition. A preferred range of proportions of the additive is in the proportion of 0.5% to 30% by weight of hydraulic cement in the composition. A further preferred range of proportions is in the proportion of 8% to 24% by weight of the hydraulic cement.

The advantage of adding the polymeric water soluble or water dispersible additive is that it provides a cementitious composition for relatively doughlike consistency which is suitable for rolling into a sheet which, prior to curing, is of a rubbery type consistency.

In another embodiment of the invention, a plasticizer is added to the cementitious composition and preferably, the plasticizer is added in a proportion of 0.1% to 40% by weight of the hydraulic cement and preferably in a proportion of 0.5% to 20% by weight of the hydraulic cement. The advantage of using a plasticizer is that it reduces the water requirement of the cementitious composition and this ultimately leads to a stronger product when the cementitious composition has cured.

In a further embodiment of the invention, the cementitious composition comprises glycerol. Preferably, the glycerol is in a proportion of from 0.05% to 15% by weight of the hydraulic cement. The advantage of adding glycerol to the cementitious composition, it has been found, is that it improves the workability of the cementitious composition, and in particular it enhances its rubber-like consistency, thereby enabling it more easily to be formed into a sheet.

In one embodiment of the invention, the cementitious composition comprises at least one particulate material which is insoluble in the composition. Preferably, the particulate material has an ultimate particle size not greater than 3 mm in diameter. Preferably, the particle size is less than 1.75 mm in diameter, and in certain preferred cases, it may be less than 600 microns. Such particulate materials may be sand, such as, for example, silica sand, such as for example fine glass making low iron sand, or fine glass making high iron sand, washed river sand, pit sand or the like. Other particulate materials may be provided by granules of plastics material, or particles of glass. Alternatively, the particles may be of steel, cast iron or any other metal, either common or precisions metal. Furthermore, the particles may be of ferrite, for example, for magnetic shielding. Indeed, particles or granules of an electrically insulating material may be provided and in certain cases these may be metal coated, metallised, vacuum metallised or the like.

The particulate material is added in the proportion of 0.1% to 80% of the hydraulic cement, and preferably, 20% to 60% by weight of the hydraulic cement.

The advantage of adding particulate material to the cementitious composition is that it further assists in strengthening the composition. Where the particle size is relatively small for example in the order of 600 microns a particularly strong mix is achieved.

In general, water is added to the cementitious composition in a proportion of not more than 40% by weight of the hydraulic cement. In fact, it has been found that by keeping the proportion of water as low as possible, a stronger mix is provided, and as mentioned earlier, the addition of a plasticiser to the cementitious mix further reduces the amount of water required.

In another embodiment of the invention, a fibrous material is added to the cementitious composition. The fibrous material may be glass fibres, metal fibres or indeed any other suitable fibres. In certain cases, it is envisaged that where the fibres are of a non-electrically conductive material they may be metal coated or metallised. Indeed, the fibres may be of any of the materials discussed with respect to the particles.

Advantageously, the fibrous material is added a proportion of 0.1% to 75% by weight of the hydraulic cement. The advantage of adding in fibrous material is that it further reinforces the product formed from the cementitious material.

In one embodiment of the invention, the suppressing means is provided by the addition of a plurality of electrically conductive particles to the composition. For example, where the particulate material is of steel, cast iron or any other metal, whether common or precious or is of an electrically conductive material, or indeed of an insulating material which is made electrically conductive by, for example, metal coating, metallising or the like, the addition of such particulate material to the cementitious composition forms a suppressing means to prevent, reduce or distort electro-magnetic signals. The addition of such particulate material is already discussed. In fact, it has been found that such electrically conductive particulate material may be added in a proportion of 0.1% to 80% of the hydraulic cement, and preferably, in a proportion of 25% to 35% by weight of the hydraulic cement. The advantages of forming the suppressing means by the addition of electrically conductive particles to the cementitious composition is that it provides a relatively low cost and effective suppressing means. Indeed, it also has been found, in many cases it adds to the strength of the product subsequently formed from the cementitious composition. Further, the suppressing means, may, if desired, be formed by the addition of fibrous material where the fibrous material is either electrically conductive or made electrically conductive by metal coating it or metallising it. The advantages of using fibrous material as a suppressing means is that it is effective in preventing, reducing or distorting electro-magnetic signals as well as providing a shield of relatively low cost and also further adds to the inherent strength of the shield produced from the cementitious composition. Needless to say, the particles or fibres where they are of an insulating material and made electrically conductive by metal coating or metallising may be coated or metallised with any suitable metal, whether a common or a precious metal. The particle size of the electrically conductive particles may be of any suitable size, however, as already discussed, they would normally be of a size not greater than 3 mm and preferably not greater than 1.75 mm. The fibres may be of any size, however, in general, it is expected that the fibres would be of diameter not greater than 1 mm and of length not greater than 400 mm, and preferably, of diameter not greater than 0.5 mm and length not greater than 400 mm. However, it will be appreciated that in many cases the particle sizes and fibre sizes will be, to some extent, determined by the thickness of the material to be produced.

Alternatively, the suppressing means comprises a metal coating extending over the interior or exterior of a portion of the housing and preferably extending over the entire housing formed from the cementitious composition. Such a metal coating may be provided by metal spluttering onto the surface of the housing, or by laminating a foil or sheet of metal onto the housing. Alternatively, the metal coating may be electrolytically deposited onto the housing or formed by vacuum metalisation. Indeed, in certain cases the coating is perforated and in certain other cases the metal coating is arranged in the form of electrical circuitry which comprises a plurality of conductors connected together and spaced apart with the spacing between the conductors being a function of the wavelength of the electro-magnetic signals to be suppressed. Provided that the conductors of the electrical circuitry are adequately spaced, it has been found that the signals are absorbed by the conductors. In fact, in certain cases it is envisaged that such conductors could be provided around the interior or exterior of the housing without being coated onto the housing, for example, they could be provided by electrically conductive bars mounted to the housing.

Indeed such conductors whether they are coated onto the housing or mounted onto the housing may be provided in pairs mounted in the form of a cross and electrically connected at their point of intersection. Where a plurality of such crosses are provided, the centre points or any other suitable points of the crosses may be connected together.

Preferably, the metal coating is of thickness not greater than 0.5 mm and advantageously, the thickness is less than 0.5 mm.

The advantage of metal coating the housing is that a relatively low cost, yet at the same time effective suppressing means for electro-magnetic waves is provided. The metals used in the metal coating may be any suitable metals, whether common metals or precious metals.

In a further alternative embodiment of the invention, the suppressing means comprises an electrically conductive mesh material formed in the cementitious composition. In which case, it is envisaged that the mesh material may be placed on a sheet of material formed by the cementitious composition and the sheet is subjected to further rolling between calendar rollers which causes the mesh to be embedded in the sheet of cementitious material. Alternatively, a sheet of mesh may be placed laminated between a pair of formed sheets which may be further subsequently rolled if desired.

The advantage of providing an electrically conductive mesh material is that a relatively inexpensive shield is provided which is effective in preventing, reducing and distorting electro-magnetic signals, and furthermore, the use of gauze further strengthens the shield.

Advantageously, an opening is provided in the housing to provide visual access to the interior of the housing, such as, for example, to provide access to a screen of a cathode ray tube. In one embodiment of the invention, the portion of the housing defining the periphery of the opening may be metallised and/or magnetised. Where it is magnetised, it has the advantage that if the opening is closed by a transparent screen which may be metal coated, a better electrically conductive joint is formed between the screen and the housing. In fact, it has been found that the addition of ferrite particles to the cementitious composition facilitates magnetisation of the housing where this is desired. Indeed, in certain cases, the transparent screen, where it is coated or metallised with an electrically conductive material to form a suppressing means may also be magnetised.

In another embodiment of the invention, one or more vent openings are provided in the housing to facilitate air circulation through the electronic apparatus. Advantageously, the vent opening is provided by a honeycomb member, and advantageously, the honeycomb member is also formed from the cementitious composition of the housing. The advantage of this is that provided the bores of the honeycomb are of suitable diameter and length, electro-magnetic signals passing through the bores of the honeycomb are attenuated to an extent that they are no longer detectable, and by virtue of the fact that the honeycomb material is formed of cementitious material with a suppressing means, further facilitates in the prevention, reduction and distortion of emitted or received signals.

Preferably, the housing is in the form of a shell formed from the cementitious composition which, in use, extends completely around the apparatus. The advantage of this is that the emission of all electro-magnetic signals from the electronic apparatus is prevented or at the very least reduced to an acceptable minimum level.

In another embodiment of the invention, the shell is formed in at least two parts, the joints between the parts forming an electrically conductive path. The advantage of this is that prevention, reduction and distortion of emitted electro-magnetic signals is further facilitated.

Preferably, the portions of the shell adjacent the joint overlap is metal coated.

The advantage of this is that the emission and/or reception of electro-magnetic signals is further reduced.

Preferably, the housing comprises a base member and a top member joined by side walls and front and rear walls, the front and rear walls being joined by the side walls. The advantage of providing the housing in this form is that a relatively low cost housing is provided which is readily easily assemblable.

Additionally, the invention provides a cabinet for electronic apparatus, the cabinet defining an interior region for receiving the electronic apparatus, and the cabinet being of a cementitious composition. The advantage of this aspect of the invention is that it provides a cabinet for electronic apparatus which is relatively lightweight and relatively inexpensive. It also provides a cabinet which can be readily easily constructed. Indeed, the cabinet according to this aspect of the invention is suitable for use as an original cabinet for electronic apparatus, or may be used as a retro-fit cabinet.

In one embodiment of the invention, the cabinet is of a cementitious mixture which comprises an hydraulic cement, and preferably, a polymeric water soluble or water dispersible additive which is capable of aiding in the processing of the composition. The advantage of this aspect of the invention, as already discussed with reference to the electro-magnetic shield is that the addition of the polymeric water soluble or water dispersible additive enables the cementitious composition to be rolled into sheets or pressed into sheets which are then suitable for forming by any suitable forming process.

Indeed, the cementitious composition of the cabinet may be similar to any of the cementitious compositions already discussed with reference to the shield, and such cementitious compositions may be provided with or without particle material, fibrous material and/or a plasticizer. Indeed, in certain cases, it is envisaged that the cementitious composition may or may not comprise glycerol.

The invention will be more clearly understood from the following description of some preferred embodiments thereof, given by way of example only, with reference to the accompanying drawings, in which:

Fig. 1 is a perspective view of a shield according to the invention,

Fig. 2 is a partly cut-away front elevational view of the shield of Fig. 1,

Fig. 3 is a top plan view of the shield of Fig. 1,

Fig. 4 is a sectional side elevational view of the shield of Fig. 1 on the line IV-IV of Fig. 3,

Fig. 5 is a cut-away perspective view of a detail of the shield of Fig. 1,

Fig. 6 is an exploded perspective view of portion of the shield of Fig. 1.

Fig. 7 is a perspective view of portion of a shield according to another embodiment of the invention, and

Fig. 8 is a plan view of portion of a shield according to a further embodiment of the invention.

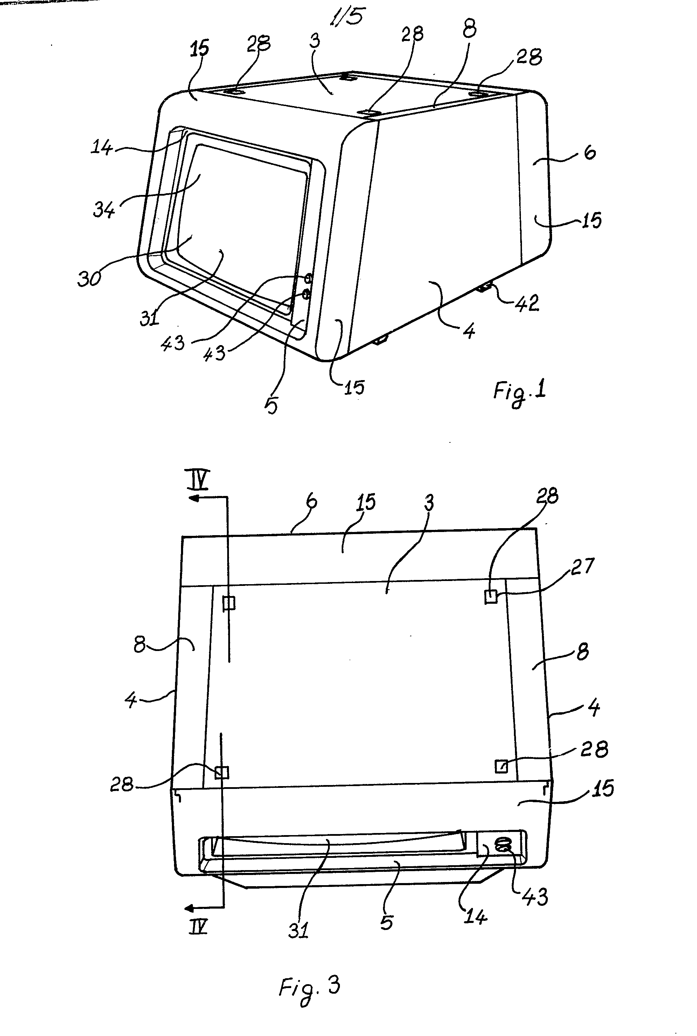

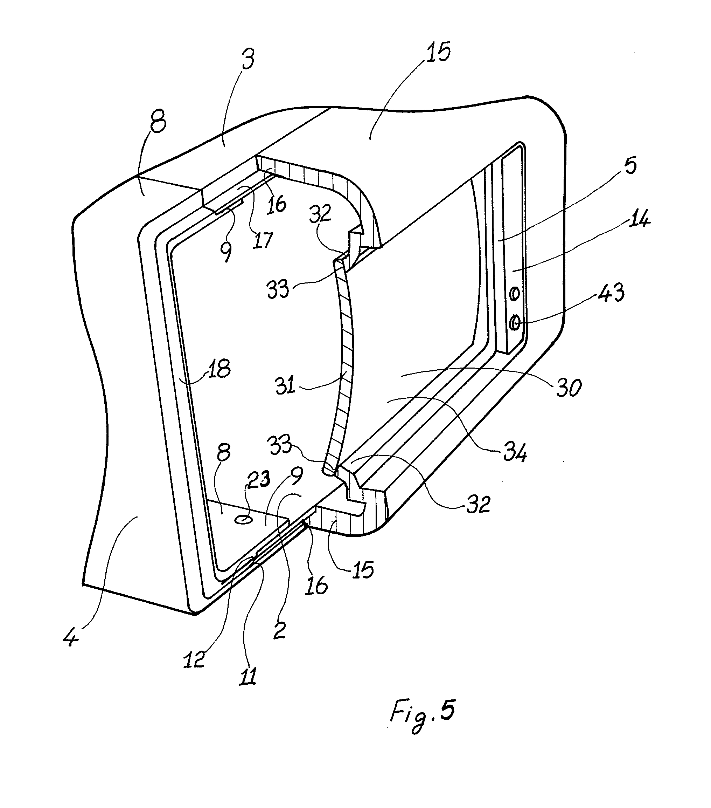

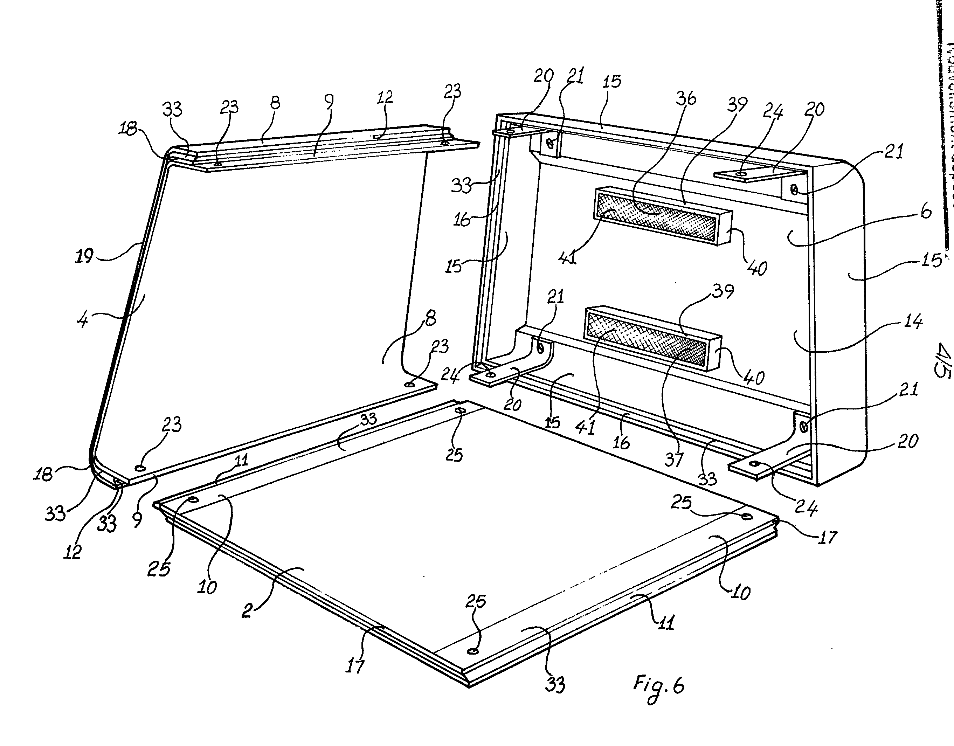

Referring to the drawings, and initially to Figs. 1 to 6 there is illustrated a shield according to the invention for preventing, reducing and/or distorting the emission of electro-magnetic signals of the type hereinbefore defined from electronic apparatus (not shown) housed within the shield. Indeed, the shield also protects the apparatus from electro-magnetic signals radiated from other sources. The shield comprises a housing, namely a cabinet indicated generally by the reference numeral 1. In this case, the cabinet 1 is for housing the electronic components and cathode ray tube of a visual display unit, none of which are shown, to prevent, reduce and/or distort the emission and/or reception of radiated electro-magnetic signals. The cabinet 1 comprises a base member 2 and a top member 3 joined by a pair of side walls 4 and front and rear walls 5 and 6 respectively. The base and top members 2 and 3, the side walls 4 and front and rear walls 5 and 6 are all manufactured of a cementitious composition which is described in detail below. A suppressing means for preventing, reducing or distorting the electro-magnetic signals in this case is provided by steel particles which are impregnated by mixing the particle into the cementitious composition during its formation. This is described in detail below. The inclusion of the steel particles in the composition makes the base and top members 2 and 3, the side walls 4 and front and rear walls 5 and 6 electrically conductive.

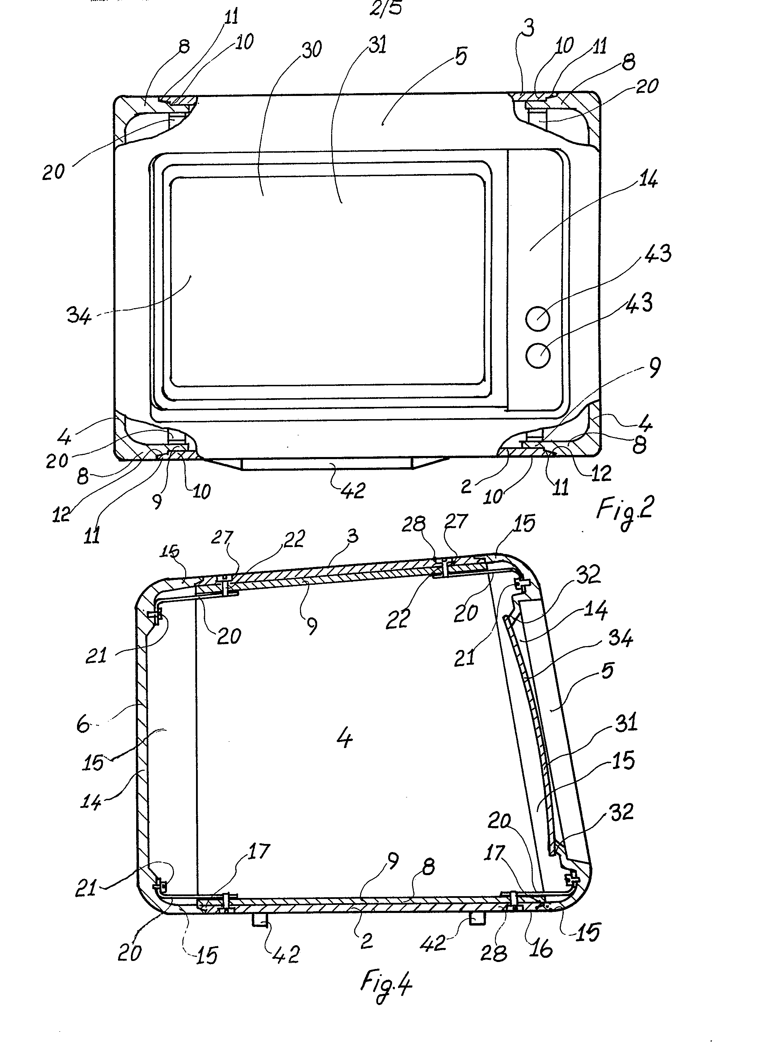

The top and bottom members 2 and 3 are in the form of flat sheets. The side walls 4 are of substantially channeled shaped construction having a pair of inwardly directed members 8 at the top and bottom thereof. The members 8 terminate in portions 9 which overlap side portions 10 of the base and top members 2 and 3. This can be seen in Fig. 2. Side portions 11 of reduced thickness on each side of the base and top members 2 and 3 engage correspondingly shaped portions 12 on the members 8 of the side walls 4. This ensures a tight secure fit between the base and top members 2 and 3 and the side walls 4. The front and rear walls 5 and 6 respectively are effectively of dish-shaped construction having a main wall 14 with inwardly extending members 15. A recess 16 is formed in the inwardly directed members 15 to engage corresponding portions 17 in the base and top members 2 and 3 and portions 18 in the side walls 4. This, as can be seen in Fig. 4, forms an overlap between the front and rear walls 5 and 6 and the base and top members 2 and 3 and the side walls 4. As can be seen in Fig. 4, the base member 2 is wider front to back than the top member 3 and edges 19 of the side walls 4 are inclined thereby giving an upward, inward slope to the front wall 5.

L-shaped brackets 20 secure the assembly together. The brackets 20 are secured by screws 21 to the front and rear walls 5 and 6. Screws 22 extending through holes 23 in the members 8 the side walls 4 and holes 25 in the base and top members 2 and 3 and engage threaded holes 24 in the brackets 20 secure the side walls 4 and top members 2 and 3 together. Recesses 27 in the base and top members 2 and 3 accommodate the heads of the screws 22 and plugs 28 in the recesses 27 cover the heads of the screws 22.

An opening 30 is provided in the front wall 5 to accommodate a transparent screen 31 to provide visual access to the screen of the cathode ray tube (not shown). An inwardly directed rim 32 is provided around the opening 30 to engage the transparent screen 31. Suitable clips (not shown) secure the screen 31 to the rim 32. The screen 31 is of transparent plastics material, in this case clear perspex. A second suppressing means is provided on the screen to prevent, reduce and distort the emission of electro-magnetic signals, and in this case the suppressing means is provided by a very fine coating of a precious metal, namely gold, which is applied to the outside surface 34 of the screen 31 by vacuum metalisation. Because the gold coating is so thin, the transparent characteristics of the perspex screen are not affected. In practice, the gold coating gives the screen a very slight hint of tinting.

As already mentioned, the suppressing means to prevent, reduce or distort the emission of electro-magnetic signals from the apparatus within the cabinet 1 is provided by mixing steel particles into the cementitious composition which is described below. However, while the inclusion of steel particles in the cementitious composition makes the walls and top and bottom members of the cabinet 1 electrically conductive, in order to ensure that the joints between the component parts of the cabinet are electrically conductive, it has been found preferable to coat the portions of the various components adjacent the joints with a metallic coating. This is done by a process known as metal spluttering where metal is spluttered onto the portions of overlap forming the joints. Accordingly, in the joints between the side walls 4 and base and top members 2 and 3, the overlapping portions, namely the portions 9, 10, 11 and 12 are coated with a coat 33 of electrically conductive metal by metal spluttering. Similarly, the recesses 16 in the front and rear walls and the portions 17 and 18 in the top and base members and side walls are similarly coated with a coat 33 of metal by the process of metal spluttering. The rim 32 where it abuts the screen 31 is also metal coated with a coat 33 by the metal spluttering process. The metal coating 33 on the rim 32 accordingly abuts the gold film on the screen 31, thereby ensuring electrical conductivity between the rim 32 and the screen 31. In fact, it has also been found desirable that the portions of the front and rear walls, side walls and top and bottom members which abut the L-shaped brackets 20 should also be coated with metal. In this case, the thickness of the metal coating is 0.25 mm.

A pair of vents, namely an upper and a lower vent 36 and 37 are provided in the rear wall 6 to permit the circulation of air to cool the apparatus within the cabinet 1. In this case, the vents 36 and 37 are provided by members 39 of honey-comb construction, also formed of the cementitious composition. The members 39 are mounted in openings 40 in the rear wall 6. In this particular embodiment of the invention, the holes 41 forming the honey-comb are of hexagonal cross-section of approximately 6 mm diameter by 15 mm long. The fact that the holes 41 are of 15 mm long effectively prevents the emission of most electro-magnetic signals, and those that are not prevented are sufficiently attenuated to be not detectable to any substantial extent. In fact, to further improve the suppressing characteristics of the vents, the cementitious composition forming the honey-comb member also includes steel particles.

Downwardly extending ribs 42 from the base member 2 form feet for the cabinet 1. Openings 43 in the front wall 5 accommodate shafts for tuning and control knobs. Sockets (not shown) are provided in the rear wall to accommodate cables, and in certain cases, it is envisaged that openings to permit the cables to enter through the rear wall may be provided and the openings would be closed by a shield means for radiated electro-magnetic signals, such as, for example, a brush shield formed from a plurality of steel bristles.

The cementitious composition forming the front, rear and side walls and top and bottom members will now be described. In this particular embodiment of the invention, a cementitious composition is prepared from the following constituents in the quantities listed below:

Hydraulic cement

    Secar 71    -  7.5 kg

    Fondu    -  3 kg

Polymeric water soluble additive Polyvinyl acetate  -  1.6 kg

Plasticiser

    Superplasticiser IBC*  -  150 ml

    Glycerol    -  200 ml

    Water    -  1,600 ml

    *Sold by Concrete Admixtures Limited of Baldoyle Industrial Estate, Dublin 13.

- 28 -

Filler

Washed river sand of particle

size not greater than 1.5 mm diameter    -  3 kg

Steel particles of particle

size not greater than 1 mm diameter    -  4.5 kg

The method for producing the cementitious composition is as follows.  The hydraulic cements, namely the secar and the fondu, the polymeric additive, namely the polyvinyl acetate, the filler, namely the sand and steel particles are placed in a Hobart mixer where they are blended into a homogenous mix.  The liquid components, namely, the glycerol, plasticiser and water are mixed together in a suitable container and are then added to the blended mixture in the Hobart mixer.  The entire mix is further mixed well to obtain a good blend by vigorous stirring in the Hobart mixer until the mixture forms a homogenous mass.

The mixture is then removed from the Hobart mixer and is worked into a rubber-like sheet by passing the mix between two high shear calandar rollers to give a workable sheet of approximately 3 mm in thickness. The sheet is then cut into pieces of desired size to form the side walls, front and rear walls and top and bottom members using any suitable cutting knife or blade.  The various components of the cabinet are formed from the appropriate pieces by pressing. The pieces are placed in appropriately shaped two piece heated moulds mounted in suitable press apparatus and are subjected to relatively low pressure, typically 600 to 800 p.s.i for approximately 15 minutes at a temperature of approximately 80°C. After pressing, the moulded components are then removed from the moulds and mounted in formers of appropriate shape for curing. It has been found that best results are achieved by curing in conditions of 40°C at 60% relative humidity for approximately 20 hours. In this way maximum strength of the material is achieved with minimum shrinkage. In practice, under these conditions shrinkage is seldom greater than 1.8% to 2%.

It is envisaged that other curing techniques may be used besides that described, and it is envisaged in certain cases that curing may take place in water, in steam or in a heated salt laden atmosphere, although needless to say, other curing techniques could be used.

It will be appreciated that the composition just described is given by way of example of a cementitious composition which may be used. Many other compositions could be used if desired without departing from the scope of the invention. Purely by way of illustrative examples, the constituents and their proportions of various other cementitious compositions are set out in Table I. Under the heading Polymer, polyvinyl acetate has been the polymer most frequently used, although in certain case polyacrylomide has been used. In all cases, the plasticiser used has been superplasticiser No. 1 sold by Concrete Admixtures Limited. Table II sets out the composition of the fillers.

Needless to say, it will be appreciated that many other cementitious compositions of other constituents and other methods of mixing may be provided without departing from the scope of the invention. Indeed, it is envisaged that cementitious compositions of the type described in European Patent Specifications Nos. 0021682 and 0038126 could also be used.

It has also been found in certain cases advantageous to include a fibrous material in the mix of the composition, such as, for example, glass fibres which may be formed by any suitable means, or may be formed by shredding glass cloth. The addition of glass fibre material, it has been found, increases the strength of the material. Indeed, any type of fibrous material may be used, such as, for example, steel fibres or the like. Furthermore, it is envisaged where fibres of an electrically insulating material are used, such as, for example, glass fibres or fibres of other plastics

| Mix | Secar 71 kg | Fondu kg | Polymer kg | Glycerol ml | Plasticizer ml | Water ml | Filler – kg | | | | | |
| --- | --- | --- | --- | --- | --- | --- | --- | --- | --- | --- | --- | --- |
| | | | | | | | Sand 1 | Sand 2 | Sand 3 | Sand 4 | C. Iron | Steel |
| A | 16 | | 1.4 | 200 | 300 | 1800 | | | | | | |
| B | 14 | | 1.4 | 200 | 250 | 1800 | | | | 4 | | |
| C | 14 | | 1.6 | 200 | 300 | 1800 | | | | 4 | | |
| D | 14 | | 1.6 | 200 | 300 | 1800 | | | 4 | | | |
| E | 10 | 4 | 1.6 | 200 | 300 | 1800 | | | 4 | | | |
| F | 12 | | 1.4 | 200 | 300 | 1800 | | | | | | 4 |
| G | 7.5 | 3 | 1.6 | 200 | 150 | 1600 | | | 3 | | | 4.5 |
| H | 14 | | 1.6 | 200 | 300 | 1800 | | | | | 4 | |
| I | 14 | | 1.4 | 200 | 200 | 1700 | | | 4 | | | |
| J | 12 | | 1.4 | 200 | 150 | 1600 | | | | | 6 | |
| K | 16 | | 1.2 | 125 | – | 2000 | | | | | | |
| L | 16 | | 1.4 | 100 | 150 | 2000 | | | | | 6 | |
| M | 12 | | 1.4 | 200 | 150 | 1600 | | | | | | 6 |
| N | 12 | | 1.8 | 200 | 150 | 1700 | | | | | | |
| O | 12 | | 1.4 | 200 | 150 | 1600 | | | | | | |
| P | 12 | | 1.4 | 200 | 150 | 1600 | 4 | | | | | |
| Q | 12 | | 1.4 | 200 | 150 | 1600 | | 4 | | | | |
| R | 12 | | 1.4 | 200 | 950 | 800 | 4 | | | | | |
| S | 12 | | 1.4 | 200 | 150 | 1600 | | | 4 | | | |
| A1 | | 15 | 1.05 | 135 | 450 | 1500 | | | | | | |
| A2 | | 16 | 1.2 | 100 | 480 | 1344 | | | | | | |
| A3 | | 16 | 0.8 | 80 | | 1680 | | | | | | |
| A4 | | 16 | 1.2 | 100 | 720 | 1344 | | | | | | |
| A5 | | 16 | 1.2 | 140 | 720 | 1600 | | | | | | |
| A6 | | 16 | 1.2 | 100 | | 1680 | | | | | | |
| A7 | | 16 | 1.1 | 110 | | 2000 | | | | | | |
| A8 | | 16 | 1.6 | 150 | | 2000 | | | | | | |
| A9 | | 16 | 1.3 | 100 | 100 | 1500 | | | | | | |
| A10 | | 16 | 0.8 | 80 | 50 | 1200 | | | | | 0.115 | |
| A11 | | 15 | 1.1 | 135 | 600 | 1500 | | | | | | |
| A12 | | 16 | 1.0 | 80 | 60 | 1500 | | | | | | |
| A13 | | 16 | 0.8 | 80 | 50 | 1400 | | | | | | |
| A14 | | 18 | 1.0 | 400 | | 1680 | | | | | | |
| A15 | 16.36 | – | 1.14 | 89.6 | | 1546 | | | | | | |

Table II

Details of fillers

Sand 1     99.9% $S_1O_2$ fine glass making low-iron
           sand ($Fe_2O_3$ less than 0.1%).  Particle
           size, 95% of particles less than 600
           microns.

Sand 2     99.6% $S_1O_2$ fine glass making high-iron
           sand ($Fe_2O_3$  0.3%).  Particle size,
           95% of particles less than 600 microns.

Sand 3     Washed "River" sand screened to remove
           particles greater than 1.5 mm diameter.

Sand 4     "Pit" sand screened to remove particles
           greater than 1.5 mm diameter.

Cast Iron  Bearings 1 mm diameter

Steel      Steel particles approximately 1 mm
           diameter.

material the fibres may be metallised by metallically coating of the individual fibres to make them electrically conductive, thereby providing suppressing means.

In another case, the components of the cabinet are formed from the cementitious materials and the panels or walls of the cabinet are reinforced with a mesh material, such as, for example, a gauze. The gauze is provided within the panels by rolling and reinforces the panel. In fact, where the gauze is of a metal material or a metallised material, namely when it is electrically conductive, it also acts as the suppressing means to prevent, reduce or distort the emission of electro-magnetic signals. To form the panels with the mesh within the panel, a sheet of the cementitious composition is formed between a pair of calandar rollers. A sheet of the gauze is then laid on top of the cementitious sheet and the sheet is subjected to further rolling. During the further and subsequent rolling, it has been found that the gauze automatically embeds itself within the cementitious sheet and remains unexposed. Furthermore, where the sheet is subsequentially being formed by moulding between a pair of press moulds, the gauze material normally remains embedded within the sheet of cementitious material.

In a cabinet formed according to another embodiment of the invention, the cabinet is similar to that illustrated in Figs. 1 to 6. However, in this case the cementitious composition of mix K of Table I is used and the suppressing means is provided by coating the entire interior of the cabinet with the exception of the screen 31 with a metal coating. The metal coating is applied by metal spluttering. The screen is formed similarly as the screen 31 described with reference to Figs. 1 to 6.

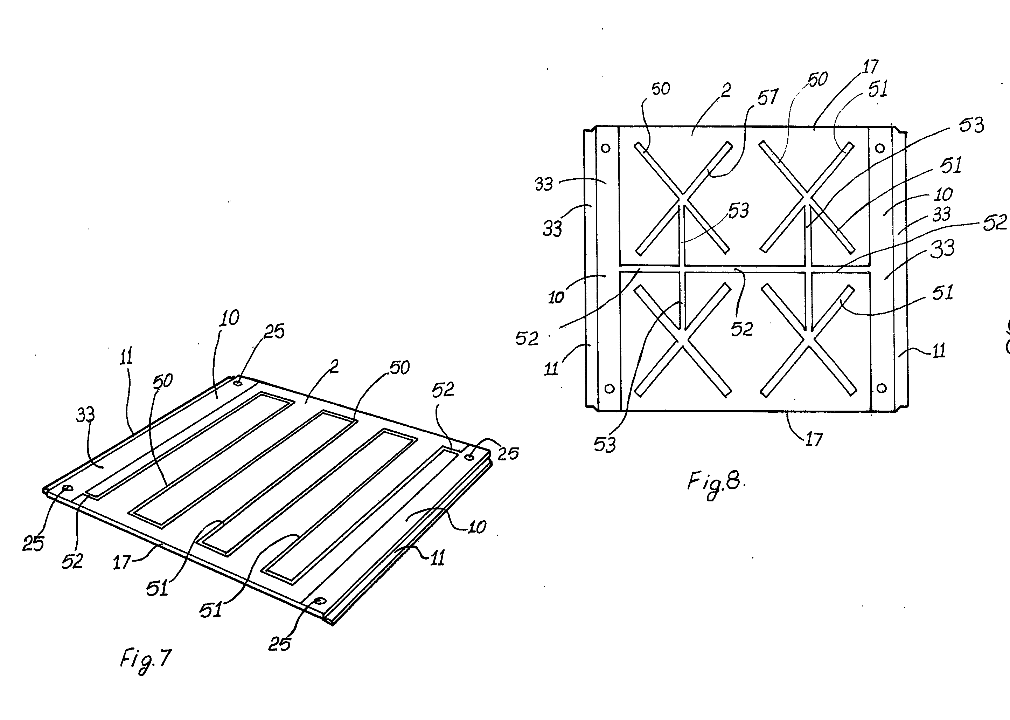

In a cabinet formed according to another embodiment of the invention, the cabinet is also similar to that illustrated in Figs. 1 to 6. In this case, the cementitious composition of mix K of Table I is also used, and the suppressing means is provided by coating the interior of the cabinet with the exception of the screen 31 with a metal coating which is arranged in the form of an electrical circuit. Fig. 7 illustrates the base member 2 of the cabinet. The electrical circuit formed by the metal coating is indicated by the reference numeral 50. The circuit 50 comprises a plurality of conducting elements 51 arranged in spaced relationship to each other. The ends 52 of the circuit 50 are electrically connected to the metal coating 33 of the joints. The electrical circuit 50 is applied to the base member 2 by metal spluttering. In practice, a mask (not shown) is placed over the inner surface of the base member 2 prior to applying the metal. In this particular case, the conductors 51 of the electrical circuit 50 are spaced apart a distance of 500 mm. This is a function of the wavelength to be suppressed, and accordingly, because the spacing between the conductors 51 is a function of the wavelength, it has been found that signals of such wavelengths are virtually totally absorbed by the electrical circuit 50. Needless to say, although not illustrated, similar electrical circuits 50 are applied to the interior of the other walls of the cabinet and these are likewise connected to the corresponding coatings 33 at the joints, thereby forming one continuous electrically conductive circuit throughout the interior of the cabinet.

Referring now to Fig. 8 there is illustrated a base member 2 of a cabinet according to another embodiment of the invention. In this case, the suppressing means is also provided by metal spluttering an electrical circuit onto the interior of the cabinet with the exception of the screen. However, in this case, the electrical circuit 50 comprises a plurality of conductors 51 arranged in pairs which cross each other. The centre points of the crosses are joined by a conductor 53. A conductor 52 joins the conductor 53 to the metal coating 33 of the joints. As with the electrical circuit 50 of the base which is illustrated in Fig. 7 all the conductors of this electrical circuit are applied to the base member 2 by metal spluttering. Needless to say, if desired, some of the conductors could be attached by other means besides metal spluttering, for example, they could be laminated, electrolytically deposited, or the like. Indeed, in certain cases, they could be secured by any suitable means, for example, adhesive, screws or the like.

By virtue of the fact that the electrical conductors 51 are arranged in pairs to form a plurality of crosses, it has been found that such arrangement is particularly effective in absorbing electro-magnetic signals.

In the embodiments of the invention where the suppressing means has been provided by a metal coating on the interior of the cabinet, either a metal coating over the entire cabinet or a metal coating provided in the form of electrical circuitry over the entire cabinet it has been found that nickle, zinc, silver and mumetal give particularly advantageous results whether used separately or in combination. While the thickness of the metal coating, be it an entire sheet over the interior of the cabinet, or an electrical circuit, or the coating 33 adjacent the joints, may be any desired thickness, it has been found in practice that a thickness of at least 0.125 mm provides particularly advantageous results.

It has also been found that suppression means besides the use of metal particles impregnated into the cementitious composition are effective, for example, steel balls, cast iron balls, indeed any other metal in particle, fibre or ball form. Indeed it has also been found that particles of ferrite are effective as suppressing means. In fact, one of the advantages of using ferrite is that the portion of the front wall around the periphery of the screen opening can be magnetized, and this further enhances the contact between the screen and the rim of the peripheral opening. Indeed, even where the cementitious material is impregnated with particles other than ferrite, magnetisation of this portion of the cabinet can also be effected. In fact, in certain cases, it is advantageous to magnetise portions of all panels, members and walls along joints to further increase electrical contact between the various panels, walls and members, or if desired, the entire cabinet may be magnetised. In certain cases, the transparent screen may also be magnetised or at least the peripheral portion in contact with the rim of the periphery of the opening may be magnetised.

- 38 -

A cabinet also according to the invention is constructed, and in this case the cabinet is made up of the cementitious composition A3 of Table 1. The cabinet is of similar construction to the cabinet illustrated in Figs. 1 to 6, with the exception that the areas of the components of the cabinet forming the joints between the walls and top and bottom members are not metallically coated. Further, the opening 30 is left open, in other words, the screen 31 is omitted. This cabinet is quite adequate as an original cabinet for the electronic components of a video display unit. Since the cementitious composition does not comprise metallic particles or fibres, this particular cabinet does not act as a shield to electro-magnetic waves. However, it is envisaged that there are many cases where such a cabinet may be desired. In fact, a particular advantage of this cabinet is because of the fact that the cabinet is of the cementitious composition A3 of Table 1, a particularly lightweight and relatively inexpensive cabinet is produced. Furthermore, the cabinet is readily easily constructed and assembled. It will, of course, be appreciated that any of the other mixes of Table 1, with or without magnetic or electrically conductive particles or fibres, could be used without departing from the scope of the invention. Indeed, it will be appreciated that many other cementitious compositions besides those listed in Table 1 could similarly be used for the cabinet without departing from the scope of the invention. Further while the cabinet of this embodiment of the invention has been described as being suitable for housing the electronic components of a visual display unit, it could be of any other shape, construction or design to house other electronic apparatus.

While in the embodiments of the invention a particular type of plasticizer has been described as used in the cementitious composition, any other suitable plasticizer could be used without departing from the scope of the invention. Indeed, in certain cases, the plasticizer may be omitted altogether. Furthermore, it is envisaged that while the cementitious mixture has been described as comprising a particular type of sand, any other suitable particulate material could be used, such as, for example, other sands or any other type of particulate material. Indeed, in certain cases, it is envisaged that the cementitious composition may omit any form of particulate material, as is illustrated in some of the mixes of Table I.

It is also envisaged that in certain cases the cementitious composition may omit glycerol, and in certain cases it is envisaged that a substitute may be provided. It is also envisaged that other polymers besides those described may be used without departing from the scope of the invention, and in certain cases the polymer may be omitted. Further, it will be appreciated that other forms of hydraulic cement besides secar 71 and fondu may be used without departing from the scope of the invention, and in many cases, one or other may be used, it is not necessary to have both. Inded, other cements besides hydraulic cement may be used. Needless to say, the quantities and proportions of constituents of the cementitious composition given in the embodiment of the invention described with reference to the figures and also those quantities and proportions set out in the tables of the specification may be varied without departing from the scope of the invention.

It will, of course, be appreciated that cabinets of other shape and construction may be provided without departing from the scope of the invention, for example, in certain cases it is envisaged that a cabinet may be formed in two pieces or any number of pieces. Additionally, while the cabinet has been described as housing electronic components and the cathode ray tube of a visual display unit which will be mounted into the cabinet in the first instance, it is envisaged that a cabinet may be provided which would be suitable for retro-fitting to existing visual display units, for example, by mounting over the existing cabinetry of an existing visual display unit.

Needless to say, it will be appreciated that cabinets of any other shape, size or construction could be provided without departing from the scope of the invention. For example, it is envisaged that such cabinets would be provided for other forms of computer apparatus, printers, keyboards, telex machines, dictating machines and the like. Further, the shield may be used for any type of apparatus which emits electro-magnetic signals of the type hereinbefore described.

Furthermore, while the shield has been described as a cabinet, it could be formed in any other way.

Additionally, it is envisaged that while the shield and cabinet have been described for preventing the emission of electro-magnetic waves from electronic apparatus, it may also be used to act to screen electronic apparatus or indeed any other apparatus from externally generated electromagnetic waves.

It will also, of course, be appreciated that other suitable methods for forming the cabinet from the cementitious composition could be used, besides rolling into sheets and forming it in moulds in a hydraulic press. For example, it is envisaged that the material could be directly moulded, for example, by injection moulding or the like. It is also

- 42 -

possible that it may be formed by rotational moulding, vacuum forming and the like. It is envisaged ther where moulds are used they need only be heated. Furthermore, other curing processes may be used without departing from the scope of the invention.

It is further envisaged that where desired pigments may be added to the cementitious composition to provide a composition of any desired colour.

It is envisaged that cabinets of considerably greater strength than that described may be provided, for example, it is envisaged in certain cases that cabinets which have similar or better electro-magnetic shielding characteristics could be constructed to be bulletproof. In which case, it is envisaged that the cabinet would be formed from a number of layers of the cementitious composition laminated with nylon mesh material, or other suitable material, between each layer. It is envisaged in certain cases that two layers with a single layer of nylon mesh material laminated between them would be adequate. In other cases, it is envisaged that the nylon mesh may be formed into a single sheet of cementitious composition by rolling a layer of mesh and a layer of the material which has already been described with regard to forming a sheet reinforced with a mesh material. Where a cabinet is desired of adequate strength to stop a shell, it is envisaged that a wall thickness of approximately 2.5 cms would be required. In this case, as many as ten layers of the cementitious composition laminated with sheets of nylon mesh between them would be required. In fact, it is envisaged that such a cabinet would be perfectly adequate for ruggidizing equipment, for example equipment for use in an army.

Further, while the transparent screen has been described as comprising a suppressing means, this while it is preferable is not essential.

It will also be appreciated that while the cabinet has been described as comprising vents of particular construction, these may be dispensed with if desired without departing from the scope of the invention. Alternatively other suitable types of vents may be provided.

Furthermore, it is envisaged that in certain cases it may not be necessary to metal coat the overlapping portions of the cabinet as an adequate electrically conductive path between the joints may be provided without such coating.

While the cabinet in some of the embodiments of the invention has been described as being metallically coated on the interior of the cabinet to form a suppression means, the metal coating could, in many cases, be formed on the outside of the cabinet, if desired. Indeed, in certain cases, it is envisaged that a metal coating may be provided on both the inside and outside of the cabinet.

CLAIMS

1.  A shield for electronic apparatus to prevent, reduce or distort emission and/or reception of radiated electro-magnetic signals of the type hereinbefore defined, the shield comprising a housing (1) defining an interior region for receiving the electronic apparatus, suppressing means for preventing, reducing or distorting the electro-magnetic signals, characterised in that at least portion of the housing (1) is of a cementitious composition.

2.  A shield as claimed in Claim 1 characterised in that the cementitious composition comprises at least one hydraulic cement.

3.  A shield as claimed in Claim 2 characterised in that the cementitious composition comprises at least one polymeric water soluble or water dispersible additive which is capable of aiding in the processing of the composition, the additive being in a proportion of 0.1% to 40% by weight of the hydraulic cement in the composition.

4.  A shield as claimed in Claim 2 or 3 characterised in that the cementitious composition comprises a plasticiser in a proportion of 0.1% to 40% by weight of the hydraulic cement.

5. A shield as claimed in any of Claims 2 to 4 characterised in that the cementitious composition comprises at least one particulate material insoluble in the composition and having an ultimate particular size of less than 3 mm in diameter, the particulate material being in a proportion of 0.1% to 80% by weight of the hydraulic cement.

6. A shield as claimed in any of Claims 2 to 5 characterised in that the cementitious composition comprises water in a proportion of not more than 40% by weight of the hydraulic cement in the composition.

7. A shield as claimed in any of Claims 2 to 6 characterised in that the cementitious composition comprises fibrous material in a proportion of 0.1% to 75% by weight of the hydraulic cement.

8. A shield as claimed in any of Claims 2 to 7 characterised in that the cementitious composition comprises glycerol.

9. A shield as claimed in any of Claims 2 to 8 characterised in that the suppressing means comprises a plurality of electrically conductive particles in the composition in a proportion of 0.1% to 80% by weight of the hydraulic cement, the electrically conductive particles being of size not greater than 3 mm in diameter.

10.   A shield as claimed in any of Claims 1 to 8 characterised in that the suppressing means comprises a metal coating extending over the interior or exterior of portion of the housing formed by the cementitious composition.

11.   A cabinet for electronic apparatus, the cabinet (1) defining an interior region for receiving the . electronic apparatus, characterised in that the cabinet is of a cementitious composition.

0250250

1/5

Fig.1

Fig. 3

Fig.2

Fig.4

Fig.5

0250250

4/5

Fig. 6

Fig.8.

Fig.7

5/5

0250250